# EUROPEAN PATENT APPLICATION

(11) **EP 4 094 991 A1**
(43) Date of publication of application: **30.11.2022**
(21) Application number: 22165443.7
(22) Date of filing: 30.03.2022
(51) Int. Cl.: B60Q 3/54, F21K 9/00, G09F 13/04, H01L 27/15, G09F 9/302, G09F 9/33, H01L 25/075, H01L 33/52, F21V 19/00, G09G 3/32, H05K 1/18, F21Y 105/10, F21Y 115/10, B60Q 3/74

(54) **VEHICLE LIGHTING DEVICE**

(30) Priority: 25.05.2021 KR 20210067212; 03.03.2022 KR 20220027638
(71) Applicant: AIT Co., Ltd., Incheon 22770 (KR)
(72) Inventor: LEE, Yong Ho, 04773 Seoul (KR)
(74) Representative: SONN Patentanwälte OG

(57) **Abstract**

A vehicle lighting device is disclosed. The vehicle lighting device according to one aspect of the present invention, which is a vehicle lighting device irradiating an interior space of a vehicle with light, includes a light emitting module configured to irradiate the interior space with light transmitted through an inner layer surrounding the interior space, wherein the light emitting module includes a substrate member formed of a flexible material, a circuit pattern printed on the substrate member and electrically conducted to the outside to receive a control signal and an applied voltage, a circuit element member configured to be coupled and electrically conducted to the circuit pattern to process the control signal and the applied voltage, and a light emitting diode (LED) member coupled to the substrate member and electrically conducted to the circuit pattern and the circuit element member to emit the light according to the control signal and the applied voltage transmitted thereto.

## Description

### CROSS-REFERENCE TO RELATED APPLICATION

This application claims priority to and the benefit of Korean Patent Application No. 2021-0067212, filed on May 25, 2021 and Korean Patent Application No. 2022-0227638, filed on March 3, 2022, the disclosure of which is incorporated herein by reference in its entirety.

### BACKGROUND

### 1. Field of the Invention

The present invention relates to a vehicle lighting device and a vehicle including the same, and more particularly, to a vehicle lighting device, which is capable of irradiating the inside of a vehicle with light while disposed in the vehicle, and a vehicle including the same.

### 2. Discussion of Related Art

In recent years, with improvements in standard of living and the increase in the importance of leisure activities, the number of people traveling away from their main living spaces has increased. For a more convenient and enjoyable trip, people tend to use private vehicles rather than public transportation.

In addition, as is well known through mass media and the like, so-called "auto-camping," in which people stay inside a vehicle instead of staying in a traditional type of accommodation, has gained sensational popularity. That is, the time people spend in the spaces inside vehicles has increased as compared to the past, and demands regarding the environment inside the vehicle, i.e., the interior, have also increased.

Accordingly, vehicle manufacturers have made various attempts to transform the space inside a vehicle into a space where people can feel comfort and enjoyment, not just a space to stay while moving.

Examples of these various attempts include improving the interior lighting with a mood lamp. In the past, generally, a room lamp or the like was used to irradiate an interior space with light to allow objects to be identified or simple tasks to be performed. However, in recent years, with the increase in the time people spend in interior spaces of vehicles as described above, demands for lighting have also diversified.

However, it is not easy to provide various types of lighting inside a vehicle. Vehicles are subject to many restrictions on their physical and electrical structure due to safety issues. For example, the interior space of a vehicle should be surrounded by a soft protective material to prevent injury to occupants in the event of a collision.

Further, in order to form various types of lighting in the interior space of a vehicle, various devices such as a large number of lamps and a wiring structure, a power source, etc. for supplying power to the lamps are required. Due to these limitations, it is difficult to secure diversity in interior lighting provided in a vehicle.

Accordingly, techniques for addressing the above problems have been introduced.

Korean Patent Registration No. 10-1684122 discloses a headlining hidden lighting device. Specifically, it discloses a lighting device which is installed on the headlining of the interior of a vehicle to implement indirect lighting that is not visible from the outside by a lighting source being inserted between the headlining fabric and a base material.

However, the headlining hidden lighting device disclosed in the above related art document has a limitation that it occupies an excessive amount of space. That is, the headlining hidden lighting device disclosed in the above related art document has a structure in which a printed circuit board (PCB) for its control is also mounted on the headlining, and there is concern that the thickness of the headlining may be increased. Accordingly, when an occupant is tall, the occupant may feel discomfort due to the occupant's head coming into contact with the headlining.

Even when the PCB is accommodated while the height of the headlining is maintained, there is still concern that the headlining hidden lighting device may occupy an excessive amount of space between the upper side of the headlining and an outer frame.

In addition, because a polyimide film material for typical flexible printed circuit boards (FPCBs) having flexibility that is disclosed in the above related art document includes a conductive thin film, a manufacturing process for configuring a circuit pattern is difficult and complicated, and heat forming is difficult, which makes it difficult to maintain and implement various designs and the shapes of corners with small curvatures.

Korean Patent Registration No. 10-1519757 discloses a vehicle mood lamp and a lighting method using the same. Specifically, it discloses a vehicle mood lamp in which an electroluminescent sheet is inserted into the skin of a headlining that surrounds an interior space to implement mood lighting in the interior of the vehicle, and a lighting method using the same.

However, it is difficult to implement various designs using the vehicle mood lamp and lighting method using the same disclosed in the above related art document. That is, although the vehicle mood lamp disclosed in the above related art document is able to change its color, no method of changing an image formed by light without changing the shape of polyurethane foam supporting a light source is proposed.

### [Related Art Documents]

### [Patent Documents]

(Patent Document 0001) Korean Patent Registration No. 10-1684122 (Date of Registration: December 8, 2016)
(Patent Document 0002) Korean Patent Registration No. 10-1519757 (Date of Registration: May 12, 2015)

### SUMMARY OF THE INVENTION

The present invention is directed to providing a vehicle lighting device which has a structure that can be effectively applied according to the shape of a vehicle, and a vehicle including the same.

The present invention is also directed to providing a vehicle lighting device which has a structure capable of irradiating a space inside a vehicle with light while maintaining the size of the space inside the vehicle, and a vehicle including the same.

The present invention is also directed to providing a vehicle lighting device which has a structure capable of forming images of various forms in a space inside a vehicle, and a vehicle including the same.

The present invention is also directed to providing a vehicle lighting device which has a structure capable of preventing damage to a component for emitting light, and a vehicle including the same.

The present invention is also directed to providing a vehicle lighting device which has a structure with an aesthetically pleasing exterior, and a vehicle including the same.

Objectives of the present invention are not limited to those mentioned above, and other unmentioned objectives should be clearly understood by those of ordinary skill in the art to which the present invention pertains from the description below.

One aspect of the present invention provides a vehicle lighting device irradiating an interior space of a vehicle with light, the vehicle lighting device including a light emitting module configured to irradiate the interior space with light transmitted through an inner layer surrounding the interior space, wherein the light emitting module includes a substrate member formed of a flexible material, a circuit pattern printed on the substrate member and electrically conducted to the outside to receive a control signal and an applied voltage, a circuit element member configured to be coupled and electrically conducted to the circuit pattern to process the control signal and the applied voltage, and a light emitting diode (LED) member coupled to the substrate member and electrically conducted to the circuit pattern and the circuit element member to emit the light according to the control signal and the applied voltage transmitted thereto.

Here, due to the inner layer, a portion of the light emitted from the LED member may be transmitted and another portion of the light may be blocked, creating an indirect mood lighting atmosphere.

Also, the substrate member may be configured to accommodate the circuit element member or the LED member to prevent protrusion thereof and may include a concavo-convex portion that is moldable by a heat forming technique, and the concavo-convex portion may include a concave portion configured to accommodate the circuit element member or the LED member and a convex portion configured to surround the concave portion.

Here, the vehicle lighting device may further include a protective layer configured to surround one or more of the substrate member, the circuit element member, and the LED member, and the protective layer may be disposed between the light emitting module and the inner layer.

Also, the protective layer may be formed by a conformal coating process or an encapsulation process or may be configured in the form of any one or more of a transparent adhesive and a transparent adhesive film.

Here, the vehicle lighting device may further include a flexible support module which is disposed between the light emitting module and the inner layer and configured to be formed to surround the circuit element member or the LED member to prevent protrusion of the circuit element member or the LED member, and in the support module, one side facing the inner layer may be formed in a shape that corresponds to the inner layer.

Also, the support module may be formed of a material that is flexible and light-permeable, and the light emitted from the light emitting module may pass through the support module and the inner layer and be radiated toward the interior space.

Here, the vehicle lighting device may further include a transmission module which is disposed between the LED member and the inner layer and includes one portion through which the light emitted from the LED member is transmitted and another portion configured to block the emitted light.

Also, the light emitted from the LED member may sequentially pass through the one portion of the transmission module and the inner layer to form a predetermined image in the interior space.

Here, the one portion of the transmission module may be formed of a character, a figure, a picture, a motion, or a combination thereof.

Also, the light emitting module may be modularized and provided as a plurality of light emitting modules, and the plurality of light emitting modules may be disposed to correspond to the shape of the inner layer.

Here, the circuit pattern may be formed on the substrate member by any one or more of printing processes including a plate-making mask, stamping, dispensing, inkjet, laser, gravure, and a pad using a conductive paste.

Also, the circuit element member and the LED member may be mounted on the substrate member by any one or more of printing processes including a plate-making mask, stamping, dispensing, inkjet, gravure, and a pad using a conductive adhesive.

Here, the light emitting module may include a dielectric region formed to cover the substrate member or the circuit pattern by any one or more of printing processes including a plate-making mask, stamping, dispensing, inkjet, laser, gravure, and a pad using a dielectric paste or a dielectric adhesive.

Also, the circuit pattern and the dielectric region may be formed as a plurality of circuit patterns and a plurality of dielectric regions, and the plurality of circuit patterns and the plurality of dielectric regions may be alternately stacked.

Here, the circuit element member and the LED member may be disposed on the plurality of circuit patterns that are alternately stacked.

Also, the LED member may be provided as any one or more of an LED, a mini LED, a micro LED, and an LED ink, and the light emitted from the LED member may have a single color, red, green, and blue (RGB), or a combination thereof.

Here, the circuit element member may be provided as a plurality of circuit element members, and the plurality of circuit element members may be configured to control the LED member according to the applied voltage and the control signal transmitted thereto.

Also, at least some of the plurality of circuit element members may be disposed apart from the substrate member.

Here, the LED member may be provided as a plurality of LED members, the plurality of LED members may be disposed in different regions of the circuit pattern, and any one or more of luminous intensity, illumination, and luminance may be higher in light emitted from the LED member disposed in one region among the plurality of LED members, as compared to light emitted from the LED member disposed in another region among the plurality of LED members.

Also, the LED member may be provided as a plurality of LED members, the plurality of LED members may be disposed in different regions of the circuit pattern, any one or more of emission of light, and the direction, luminous intensity, illumination, luminance, and color of the emitted light may be independently controlled for the plurality of LED members, and the light emitted from the plurality of LED members may form an image of a character, a figure, a picture, a motion, or a combination thereof.

Here, the substrate member may be formed of any one or more of a synthetic resin film, leather, artificial leather, fabric, nonwoven fabric, foam, and felt.

Also, one aspect of the present invention provides a vehicle including an inner layer surrounding an interior space, a mold layer stacked while surrounding the inner layer from an outer side thereof, and a vehicle lighting device disposed between the inner layer and the mold layer to irradiate the interior space with light, wherein the vehicle lighting device includes a light emitting module configured to irradiate the interior space with light transmitted through the inner layer, the light emitting module includes a substrate member formed of a flexible material, a circuit pattern printed on the substrate member and electrically conducted to the outside to receive a control signal and an applied voltage, a circuit element member configured to be coupled and electrically conducted to the circuit pattern to process the control signal and the applied voltage, and an LED member coupled to the substrate member and electrically conducted to the circuit pattern and the circuit element member to emit the light according to the control signal and the applied voltage transmitted thereto, and a portion of the light emitted from the LED member is transmitted through the inner layer and advances into the interior space while the rest of the light is blocked by the inner layer.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG 1 shows a lateral cross-sectional view and an enlarged view of a vehicle including a vehicle lighting device according to an embodiment of the present invention;
FIG 2 is a conceptual diagram illustrating a light emitting module of the vehicle lighting device according to an embodiment of the present invention;
FIG 3 is a block diagram illustrating a configuration of the light emitting module of the vehicle lighting device according to an embodiment of the present invention;
FIG 4 is a lateral cross-sectional view illustrating a state in which the vehicle lighting device is disposed in the vehicle according to an embodiment of the present invention;
FIG. 5 is a lateral cross-sectional view illustrating a vehicle lighting device according to another embodiment of the present invention;
FIG. 6 is a lateral cross-sectional view illustrating a vehicle lighting device according to still another embodiment of the present invention;
FIG. 7 is a lateral cross-sectional view illustrating a vehicle lighting device according to yet another embodiment of the present invention;
FIG. 8 is a lateral cross-sectional view illustrating a vehicle lighting device according to yet another embodiment of the present invention;
FIG. 9 is a lateral cross-sectional view illustrating a vehicle lighting device according to yet another embodiment of the present invention;
FIG. 10 is a plan view illustrating a transmission module according to an embodiment of the present invention; and
FIGS. 11 to 16 are conceptual diagrams illustrating operation states of the vehicle lighting device according to an embodiment of the present invention.

### DETAILED DESCRIPTION OF EXEMPLARY EMBODIMENTS

Hereinafter, embodiments of the present invention will be described in detail with reference to the accompanying drawings to allow those of ordinary skill in the art to which the present invention pertains to easily practice the present invention. The present invention may be implemented in various different forms and is not limited to the embodiments described herein. In order to clearly describe the present invention, parts unrelated to the description have been omitted from the drawings, and the same or similar elements will be denoted by the same reference numerals throughout the specification.

Terms used in this specification and the claims should be construed as having meanings and concepts that are consistent with the technical spirit of the present invention according to the principle that the inventor may define terms and concepts to describe his or her invention in the best way, rather than being construed as having general or dictionary meanings and being limited thereto.

Therefore, embodiments described in this specification and configurations illustrated in the drawings correspond to exemplary embodiments of the present invention and do not represent the entire technical spirit of the present invention. Thus, various equivalents and modifications that may replace the corresponding configurations may be present at the time of filing of this application.

In the following description, descriptions of some components may be omitted to clarify features of the present invention.

The term "electrically conducted" used in the following description refers to a state in which one or more members are connected to be able to transmit and receive electricity or electronic signals to and from each other. In one embodiment, electrical conduction may be implemented in a wired form using a lead wire member or the like or implemented in a wireless form using Bluetooth, Wi-Fi, RFID, etc.

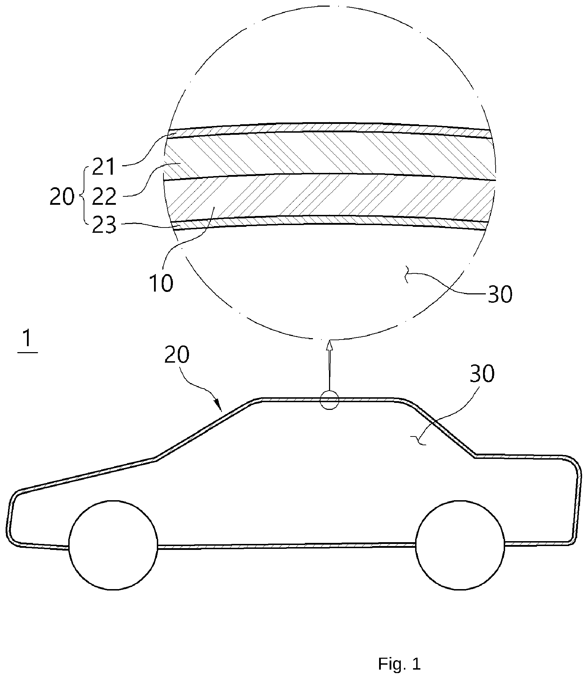

Referring to FIG. 1, a state in which a vehicle lighting device 10 according to an embodiment of the present invention is disposed in a vehicle 1 is illustrated as an example. The vehicle lighting device 10 may be mounted inside a frame 20 that constitutes an exterior of the vehicle 1.

Specifically, the frame 20 is formed to surround an interior space 30, i.e., a space configured to accommodate an occupant or an object, that is formed inside the vehicle 1. In other words, the interior space 30 is a space formed to be surrounded by the frame 20.

Here, the vehicle lighting device 10 according to an embodiment of the present invention is configured to be accommodated inside the frame 20 to irradiate the interior space 30 with light L. To this end, the vehicle lighting device 10 may be coupled to the frame 20, and the light L radiated from the vehicle lighting device 10 may pass through some layers of the frame 20 and extend into the interior space 30.

The frame 20 may be formed in any shape that allows the frame 20 to form the exterior of the vehicle 1, surround the interior space 30, and protect an occupant or an object accommodated in the interior space 30. In the illustrated embodiment, the frame 20 includes an outer layer 21, a mold layer 22, and an inner layer 23.

The outer layer 21 forms an outer surface of the frame 20. The outer layer 21 is a portion where the frame 20 is exposed at the outside of the vehicle 1. As is known, the outer layer 21 may be formed of a rigid body and protect the interior space 30 from impact applied from the outside.

The mold layer 22 forms an intermediate portion of the frame 20. The mold layer 22 is coupled to each of the outer layer 21 and the inner layer 23.

The inner layer 23 forms an inner surface of the frame 20. The inner layer 23 surrounds the interior space 30. In other words, the inner layer 23 is a portion that is exposed in the interior space 30 and comes in direct contact with the occupant or object accommodated in the interior space 30.

Therefore, in order to increase comfort of the occupant accommodated in the interior space 30, the inner layer 23 may be formed of a fabric material. In one embodiment, the inner layer 23 may be formed of a leather material.

In particular, the inner layer 23 according to an embodiment of the present invention may be formed of a light-permeable material. The light L emitted from the vehicle lighting device 10 may pass through the inner layer 23 and extend into the interior space 30.

The inner layer 23 may be formed in a shape that corresponds to the shape of the outer layer 21. That is, with regards to an exterior of a typical vehicle 1, the outer layer 21 is formed to include both a flat surface and a curved surface. Thus, the inner layer 23 may also be formed to include both a flat surface and a curved surface in order to correspond to the shape of the outer layer 21. This may be achieved by characteristics of the above-mentioned materials of the inner layer 23.

The vehicle lighting device 10 according to an embodiment of the present invention may be configured to be coupled to the mold layer 22 and radiate the light L toward the inner layer 23. That is, the vehicle lighting device 10 is disposed between the mold layer 22 and the inner layer 23.

Therefore, with regards to the cross-section of the vehicle 1, the inner layer 23, the vehicle lighting device 10, the mold layer 22, and the outer layer 21 are sequentially stacked in that order in a direction from the interior space 30 toward the outside.

The frame 20 may be any point forming the exterior and interior of the vehicle 1. In the illustrated embodiment, the frame 20 is a ceiling portion, i.e., a headlining portion, that is disposed at an upper side of the vehicle 1.

As an alternative, the frame 20 may be any point at least partially surrounding the interior space 30 of the vehicle 1 that includes a trim, a dashboard, a pillar, a rear portion, a front portion, and the like disposed in the vehicle 1 to form an inner side thereof.

That is, the vehicle lighting device 10 according to an embodiment of the present invention is not limited to being disposed at the ceiling portion of the vehicle 1 but may be disposed at any point of the vehicle 1, such as a sun visor, a sunroof cover, an assist handle, a door trim, a dashboard, a garnish, a center console, a console box, a seat, a door scuff, a car seat, or a car mat to irradiate the interior space 30 with the light L.

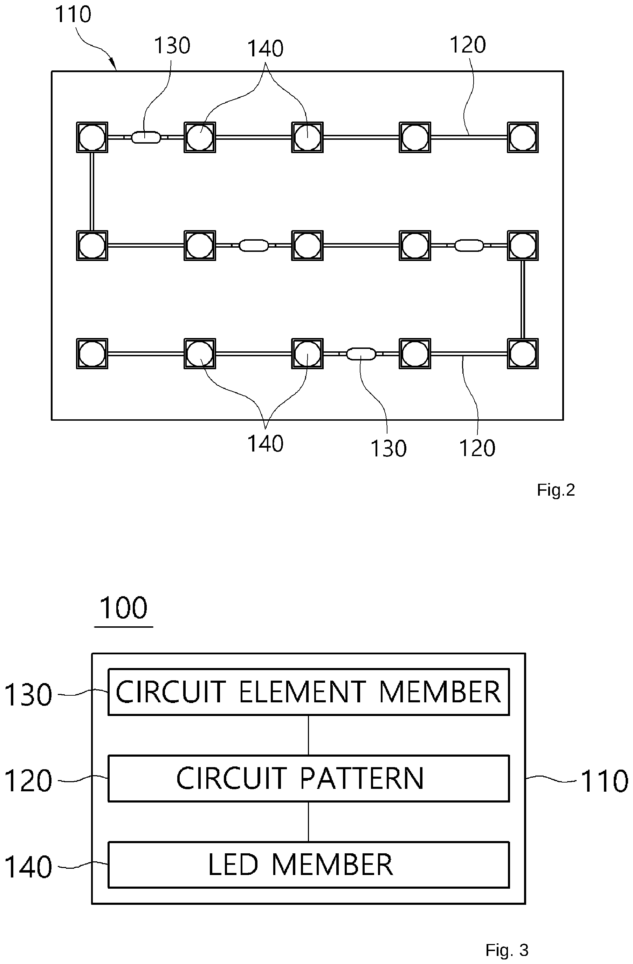

Hereinafter, a configuration of the vehicle lighting device 10 according to an embodiment of the present invention will be described in detail with reference to FIGS. 2 to 10.

The vehicle lighting device 10 according to an embodiment of the present invention may be disposed inside the frame 20, specifically, between the mold layer 22 and the inner layer 23, to radiate the light L that passes through the inner layer 23. The light L radiated by the vehicle lighting device 10 may extend into the interior space 30 and form images of various forms.

As will be described below, the light L radiated by the vehicle lighting device 10 according to an embodiment of the present invention may form an image of a character, a figure, a picture, a motion, or a combination thereof.

The formed image may be formed on the inner layer 23 of the frame 20 and visually recognized by the occupant accommodated in the interior space 30. Accordingly, comfort and an emotional sense of stability of the occupant accommodated in the interior space 30 may be improved. This will be described in detail below.

In particular, the vehicle lighting device 10 according to an embodiment of the present invention may be formed to correspond to the above-described shape of the frame 20, i.e., the shape that includes both a flat surface and a curved surface. Therefore, the vehicle lighting device 10 may be stably coupled to the frame 20, and the volume of the interior space 30 that is occupied by the vehicle lighting device 10 may be reduced.

In one embodiment, the vehicle lighting device 10 may be formed in a shape which is the same as the shape of the inner layer 23 and disposed to cover the inner layer 23. In this embodiment, the vehicle lighting device 10 may be provided as a single member and disposed to be stacked on the inner layer 23.

In another embodiment, the vehicle lighting device 10 may have a shape corresponding to the inner layer 23 but have an area smaller than the area of the inner layer 23. In this embodiment, the vehicle lighting device 10 may be provided as a plurality of vehicle lighting devices 10, and the plurality of vehicle lighting devices 10 may be stacked to partially cover the inner layer 23. That is, in this embodiment, the vehicle lighting device 10 may be provided to be modular.

Therefore, it may be said that the vehicle lighting device 10 at least partially surrounds the inner layer 23 and the interior space 30 that is surrounded by the inner layer 23.

In the illustrated embodiment, the vehicle lighting device 10 includes a light emitting module 100, a support module 200, and a transmission module 300.

Here, the support module 200 and the transmission module 300 may be selectively included. In other words, the vehicle lighting device 10 may only include the light emitting module 100 or may further include any one or more of the support module 200 and the transmission module 300.

Therefore, it should be understood that application of various forms of modifications is possible according to conditions of the vehicle 1 in which the vehicle lighting device 10 is included.

The light emitting module 100 is a portion where the vehicle lighting device 10 is coupled to the mold layer 22. One surface of the light emitting module 100 that faces the mold layer 22, an upper surface of the light emitting module 100 in the illustrated embodiment, is coupled to a lower surface of the mold layer 22. In other words, the inner layer 23, the light emitting module 100, and the mold layer 22 are sequentially stacked in that order in the direction from the interior space 30 toward the outside.

Also, the light emitting module 100 is electrically conducted to the outside to receive an applied voltage and a control signal and emits the light L accordingly. As described above, an image is formed on the inner layer 23 or in the interior space 30 due to the emitted light L.

The light emitting module 100 may be formed in a shape that corresponds to the shape of the frame 20. As described above, the frame 20 is formed in the shape of a plate that includes both a flat surface and a curved surface. Accordingly, the light emitting module 100 may also be formed in the shape of a plate including both a flat surface and a curved surface and may be adhered and coupled to the frame 20.

The light emitting module 100 may constitute a body of the vehicle lighting device 10. The light emitting module 100 may be formed in a shape that corresponds to the shape of the mold layer 22 or the inner layer 23 which is coupled to the light emitting module 100.

As described above, in one embodiment, the vehicle lighting device 10 may be provided to have an area equal to the area of the mold layer 22 or the inner layer 23. In this embodiment, the light emitting module 100 may be formed to have an area equal to the area of the mold layer 22 or the inner layer 23. In this embodiment, a single light emitting module 100 may be disposed to surround the inner layer 23 and the interior space 30 surrounded by the inner layer 23.

Also, in another embodiment, the vehicle lighting device 10 may be provided to have an area smaller than the area of the mold layer 22 or the inner layer 23. In this embodiment, the light emitting module 100 may be formed to have an area smaller than the area of the mold layer 22 or the inner layer 23. In this embodiment, each of a plurality of light emitting modules 100 may be disposed to partially surround the inner layer 23 and the interior space 30 surrounded by the inner layer 23. That is, in this embodiment, the light emitting module 100 may be modularized and provided as a plurality of light emitting modules 100, and the plurality of light emitting modules 100 may be disposed in a direction extending in the shape of the inner layer 23.

In an embodiment illustrated in FIGS. 2 and 3, the light emitting module 100 includes a substrate member 110, a circuit pattern 120, a circuit element member 130, a light emitting diode (LED) member 140, a concavo-convex portion 150, and a protective layer 160.

The substrate member 110 forms a body of the light emitting module 100. The substrate member 110 is a portion where the light emitting module 100 is coupled to the frame 20, specifically, the mold layer 22.

The circuit pattern 120 is formed on the substrate member 110. In one embodiment, the circuit pattern 120 may be printed on the substrate member 110 by any one or more of printing processes including a plate-making mask, stamping, dispensing, inkjet, laser, gravure, and a pad using a conductive paste.

That is, in this embodiment, the circuit pattern 120 may be formed on the substrate member 110 using a conductive material.

Here, a dielectric region formed using a dielectric material may be formed on the substrate member 110 or the circuit pattern 120.

That is, the dielectric region may be formed on the substrate member 110 or the circuit pattern 120 by any one or more of printing processes including a plate-making mask, stamping, dispensing, inkjet, laser, gravure, and a pad using a dielectric paste or dielectric adhesive.

Also, the circuit pattern 120 and the dielectric region formed on the substrate member 110 may be formed as a plurality of circuit patterns 120 and a plurality of dielectric regions. The plurality of circuit patterns 120 and the plurality of dielectric regions may be alternately stacked on the substrate member 110.

In one embodiment, the circuit element member 130 and the LED member 140 may be disposed on the plurality of circuit patterns 120 and the plurality of dielectric regions that are alternately stacked.

The plurality of circuit patterns 120, the circuit element member 130, and the LED member 140 which are formed on the substrate member 110 are coupled and electrically conducted.

In one embodiment, the circuit element member 130 and the LED member 140 may be applied onto the substrate member or the circuit pattern by any one or more of printing processes including a plate-making mask, stamping, dispensing, inkjet, gravure, and a pad using a conductive adhesive and may be coupled to the circuit pattern 120 formed on the substrate member 110 by a typical bonding process.

That is, in this embodiment, the circuit element member 130 and the LED member 140 may be coupled and electrically conducted to the circuit pattern 120 formed on the substrate member 110 using a conductive material.

As an alternative, in order to strengthen the adhesion of the circuit element member 130 and the LED member 140, a dielectric material may be used for coupling of the circuit element member 130 and the LED member 140 to the circuit pattern 120 formed on the substrate member 110.

That is, the circuit element member 130 and the LED member 140 may be applied onto the substrate member 110 or the circuit pattern 120 by any one or more of printing processes including a plate-making mask, stamping, dispensing, inkjet, laser, gravure, and a pad using a dielectric adhesive and may be coupled to the circuit pattern 120 formed on the substrate member 110 by a typical bonding process to increase element adhesion.

That is, in one embodiment, the circuit element member 130 and the LED member 140 may be applied onto the circuit pattern by any one or more of printing processes including a plate-making mask, stamping, dispensing, inkjet, laser, gravure, and a pad using a dielectric paste to constitute multiple circuit layers.

The substrate member 110 may be formed in the shape of a plate. The circuit pattern 120 may be formed on one surface of the substrate member 110 that faces the interior space 30, a lower surface of the substrate member 110 in the illustrated embodiment, and the circuit element member 130 is coupled and electrically conducted to the circuit pattern 120. The LED member 140 may be coupled to the lower surface and electrically conducted to the circuit pattern 120 and the circuit element member 130.

The other surface of the substrate member 110 that is opposite to the interior space 30, an upper surface of the substrate member 110 in the illustrated embodiment, is coupled to the mold layer 22. In one embodiment, the other surface of the substrate member 110 may be fixed and coupled to the mold layer 22.

The substrate member 110 may be formed of a flexible material. Accordingly, the plate-shaped substrate member 110 may be deformed to correspond to the shape of the mold layer 22 or inner layer 23. Therefore, it should be understood that the substrate member 110 and the mold layer 22 may be adhered and coupled to each other.

In one embodiment, the substrate member 110 may be formed of any one or more of a synthetic resin film, leather, artificial leather, fabric, nonwoven fabric, foam, and felt.

The plate-shaped substrate member 110 may extend in an arbitrary direction. For example, in an embodiment in which the vehicle lighting device 10 is disposed at the ceiling portion of the vehicle 1, the plate-shaped substrate member 110 may extend in the left-right direction and front-rear direction to correspond to the ceiling portion. The shape of the substrate member 110 may be changed to correspond to the shape of the frame 20 coupled thereto.

In one embodiment, the plate-shaped substrate member 110 may be formed to have an area that corresponds to the area of the frame 20. In this embodiment, the light emitting module 100 may be provided as a single light emitting module 100, and a single substrate member 110 may be configured to cover the entire frame 20. Accordingly, the single substrate member 110 may be disposed to cover the entire inner layer 23.

In another embodiment, the plate-shaped substrate member 110 may be formed to have an area smaller than the area of the frame 20. In this embodiment, the substrate member 110 may be provided as a plurality of substrate members 110. Each of the plurality of substrate members 110 may be disposed to at least partially cover the inner layer 23. Accordingly, the plurality of substrate members 110 may be disposed to cover the inner layer 23 together.

That is, in this embodiment, it should be understood that the light emitting module 100 is provided to be modular. In this embodiment, the plurality of substrate members 110 may be disposed in any form that allows the plurality of substrate members 110 to cover the inner layer 23. In one embodiment, the substrate members 110 may be disposed to be parallel in the left-right direction and front-rear direction.

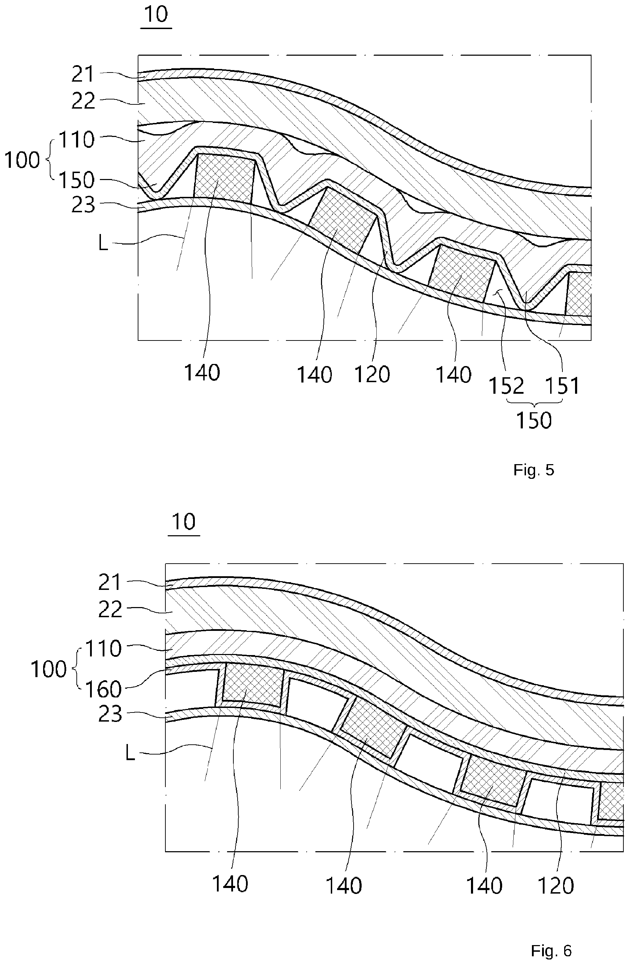

Referring to FIG. 5, the light emitting module 100 according to an illustrated embodiment includes the concavo-convex portion 150. In the illustrated embodiment, the concavo-convex portion 150 is integrally formed with the substrate member 110. That is, the concavo-convex portion 150 may constitute one portion of the substrate member 110 and form one side of the substrate member 110 that faces the inner layer 23.

The concavo-convex portion 150 includes a convex portion 151 configured to surround the circuit element member 130 or the LED member 140 and a concave portion 152 configured to accommodate the circuit element member 130 or the LED member 140. As the concavo-convex portion 150 is formed, the circuit element member 130 or the LED member 140 is prevented from protruding past the substrate member 110.

Therefore, although the LED member 140 is illustrated as being accommodated in and protected by the concavo-convex portion 150 in this embodiment, it should be understood that the circuit element member 130 may also be accommodated in and protected by the concavo-convex portion 150.

The convex portion 151 and the concave portion 152 that constitute the concavo-convex portion 150 may be provided as a plurality of convex portions 151 and a plurality of concave portions 152. The plurality of convex portions 151 and the plurality of concave portions 152 may be consecutively disposed alternately in a direction in which the substrate member 110 extends or a direction in which a plurality of LED members 140 extend.

The convex portion 151 is integrally formed with the substrate member 110 and formed to protrude toward the inner layer 23 or the interior space 30, i.e., downward in the illustrated embodiment. One surface of the convex portion 151 in an extending direction thereof, a lower surface of the convex portion 151 in the illustrated embodiment, may extend to the inner layer 23 and come into contact with the inner layer 23.

Therefore, in this embodiment, the upper surface of the substrate member 110 is coupled to and supported by the mold layer 22. Also, the lower side of the circuit element member 130 or LED member 140 may be supported by contact between the convex portion 151 and the inner layer 23. Accordingly, the light emitting module 100 may be more stably coupled to the frame 20.

In one embodiment, a length that the convex portion 151 extends may be determined to correspond to the shape of the inner layer 23 and LED member 140. That is, a virtual surface connecting a surface where the convex portion 151 comes into contact with the inner layer 23 and a surface where the LED member 140 comes into contact with the inner layer 23 may be formed to correspond to the shape of the inner layer 23.

In this embodiment, from the view of the occupant accommodated in the interior space 30, the inner layer 23 may be maintained as a smoothly extending flat surface or curved surface. Accordingly, the exterior of the inner layer 23 may be aesthetically pleasing, and the occupant's satisfaction may be improved.

The concave portion 152 is a space in which the circuit element member 130 or the LED member 140 is accommodated. The concave portion 152 is formed between a pair of convex portions 151 disposed adjacent to each other. In the illustrated embodiment, the concave portion 152 is defined as a space surrounded by the substrate member 110, the pair of convex portions 151, and the inner layer 23.

The concave portion 152 accommodates the LED member 140. In this embodiment, the LED member 140 accommodated in the concave portion 152 may be supported by the pair of convex portions 151 disposed adjacent to each other and the inner layer 23. Accordingly, the position of the LED member 140 and a state in which the LED member 140 is coupled to the substrate member 110 may be stably maintained.

The circuit pattern 120 is configured to be electrically conducted to the outside to receive an applied voltage and a control signal. The received applied voltage and control signal are transmitted to the circuit element member 130 and the LED member 140 which are coupled and electrically conducted to the circuit pattern 120. The LED member 140 may be operated according to the received applied voltage and control signal and emit the light L in various forms.

The circuit pattern 120 is formed on the substrate member 110. As described above, the circuit pattern 120 is made of a conductive material and formed on the substrate member 110. In one embodiment, the circuit pattern 120 may be printed on the substrate member 110.

The circuit pattern 120 is coupled and electrically conducted to the circuit element member 130. The applied voltage and control signal transmitted to the circuit pattern 120 may be transmitted to the circuit element member 130.

The circuit pattern 120 is coupled and electrically conducted to the LED member 140. The applied voltage and control signal transmitted to the circuit pattern 120 may be transmitted to the LED member 140.

The circuit element member 130 is configured to control the LED member 140 according to the applied voltage and control signal transmitted to the circuit pattern 120. The circuit element member 130 is coupled to the circuit pattern 120. The circuit element member 130 may be provided as a plurality of circuit element members 130 that are electrically conducted to each other. Also, the circuit element member 130 is electrically conducted to the LED member 140.

The circuit element member 130 may be provided in any form that allows the circuit element member 130 to process the received applied voltage and control signal and control the LED member 140 on the basis of the processed applied voltage and control signal. In one embodiment, the circuit element member 130 may be provided as a driving and control element or the like that includes a capacitor, a diode, and an integrated circuit.

The circuit element member 130 may be provided as a plurality of circuit element members 130. The plurality of circuit element members 130 may be electrically conducted to each other and may process the received applied voltage and control signal and control the LED member 140 using the processed applied voltage and control signal. Therefore, it should be understood that the plurality of circuit element members 130 may be defined as a "control unit."

In one embodiment, some of the plurality of circuit element members 130 may be disposed apart from the substrate member 110. In other words, some of the plurality of circuit element members 130 may be disposed outside the substrate member 110.

In this embodiment, some of the plurality of circuit element members 130 may be coupled to a controller (not illustrated) included in the vehicle 1 or may be provided as a separate controller.

The LED member 140 radiates the light L for forming an image in the interior space 30. The light L emitted from the LED member 140 may pass through the inner layer 23 and extend into the interior space 30. In one embodiment, the light L emitted from the LED member 140 may be formed on the inner layer 23 and form an image or may be directly transmitted to the occupant accommodated in the interior space 30.

The LED member 140 may perform dot illumination. Accordingly, the light L emitted from the LED member 140 may also be formed in the shape of a dot. In an embodiment in which the LED member 140 is provided as a plurality of LED members 140, dots formed by rays of light L emitted from the plurality of LED members 140 may be consecutively arranged to form a predetermined image.

The LED member 140 is coupled to the formed circuit pattern 120. In the illustrated embodiment, the LED member 140 is coupled to one surface of the substrate member 110 that faces the inner layer 23, that is, the lower surface of the substrate member 110. It should be understood that the one surface of the substrate member 110 is the same as a surface on which the circuit pattern 120 is printed and to which the circuit element member 130 is coupled.

Therefore, the LED member 140 may protrude toward the inner layer 23 past the substrate member 110. Accordingly, the shape of the inner layer 23 may be deformed due to the LED member 140, or the LED member 140 may be damaged due to an external force applied through the inner layer 23. In order to prevent this, the concavo-convex portion 150 may be disposed in the light emitting module 100 according to an embodiment of the present invention. This will be described in detail below.

The LED member 140 and the circuit element member 130 are each coupled and electrically conducted to the circuit pattern 120. An applied voltage and a control signal necessary for the LED member 140 to be operated may be transmitted from the circuit pattern 120 and the circuit element member 130.

The LED member 140 may be provided in any form that allows the LED member 140 to receive the applied voltage and the control signal and be operated accordingly to radiate the light L. In one embodiment, the LED member 140 may be provided as any one or more of an LED, a mini LED, a micro LED, and an LED ink.

The LED member 140 may be configured to radiate the light L of any color. In one embodiment, the LED member 140 may be configured to radiate the light L having a single color, red, green, and blue (RGB), or a combination thereof. Accordingly, an image formed by the LED member 140 may be formed to have one or more colors.

The LED member 140 is disposed in a space formed between the substrate member 110 and the inner layer 23. The LED member 140 is disposed between the circuit pattern 120 formed on the substrate member 110 and the inner layer 23.

In the illustrated embodiment, an upper end portion of the LED member 140 is coupled and electrically conducted to the circuit pattern 120 formed on the substrate member 110. A lower end portion of the LED member 140 is disposed adjacent to the inner layer 23.

The LED member 140 may be provided as a plurality of LED members 140. Any one or more of emission of the light L, and the direction, illumination, luminous intensity, luminance, and color of the emitted light L may be independently controlled for the plurality of LED members 140.

Accordingly, the light L emitted from the plurality of LED members 140 may form various images. Further, the light L emitted from the plurality of LED members 140 may also form an image in the form of motion.

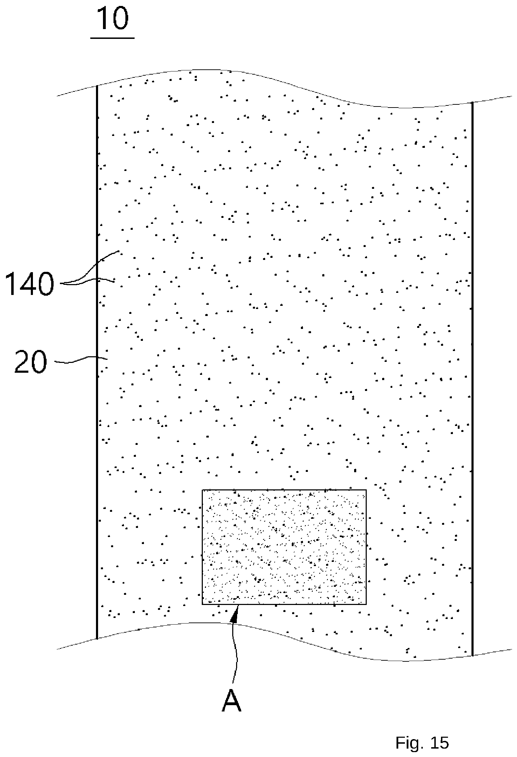

Here, a specific region among a plurality of regions of the substrate member 110 may be defined as an intensive region A (see FIG. 15).

In this embodiment, any one or more of illumination, luminous intensity, and luminance may be higher in the light L radiated from the LED member 140 disposed in the intensive region A among the plurality of LED members 140, as compared to the light L radiated from the LED member 140 disposed in a region other than the intensive region A.

That is, the LED member 140 disposed in the intensive region A may emit the light L that is relatively brighter than the light L emitted from the LED member 140 disposed in another region and may serve as indoor light, i.e., a room lamp. In this embodiment, since it is not necessary to provide a separate room lamp on the ceiling portion of the vehicle 1, the exterior of the interior space 30 may become more aesthetically pleasing, and efficiency of tasks for manufacturing the vehicle 1 may be improved.

The plurality of LED members 140 may be operated in various forms to form images of various forms in the interior space 30. This will be described in detail below.

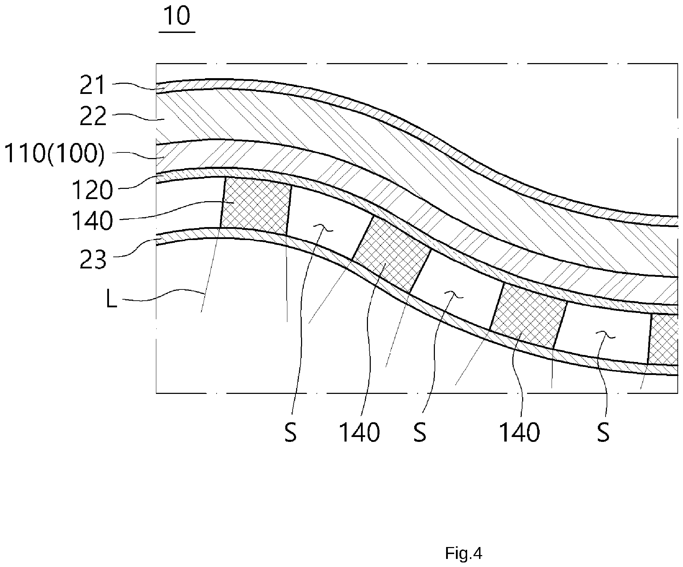

In the embodiment illustrated in FIG. 4, the light emitting module 100 is provided to include the circuit pattern 120 formed on the substrate member 110 and the LED member 140. In this embodiment, the LED member 140 coupled and electrically conducted to the circuit pattern 120 formed on the substrate member 110 is disposed toward the one surface of the substrate member 110, that is, the lower surface of the substrate member 110.

Accordingly, a space, i.e., a separation space S, that is surrounded by the inner layer 23 and the substrate member 110 is formed between each pair of LED members 140 disposed adjacent to each other among the plurality of LED members 140.

In this embodiment, a thickness of the space occupied by the vehicle lighting device 10 may be minimized. Accordingly, the vehicle lighting device 10 may be provided without excessively reducing the interior space 30.

Referring to FIG. 6, the light emitting module 100 according to an illustrated embodiment includes a protective layer 160.

The protective layer 160 is disposed to surround the substrate member 110, the circuit pattern 120, the circuit element member 130, or the LED member 140 to protect the components. The protective layer 160 may be configured to protect the substrate member 110, the circuit pattern 120, the circuit element member 130, or the LED member 140 from physical impact, environmental impact such as humidity and temperature, and electrical impact.

The protective layer 160 may be provided in any form that allows the protective layer 160 to protect the substrate member 110, the circuit pattern 120, the circuit element member 130, or the LED member 140. In the embodiment illustrated in FIG. 6, the protective layer 160 may be disposed between the substrate member 110 and the LED member 140 and inner layer 23 and formed to surround the substrate member 110 and the LED member 140 from a lower side thereof.

Accordingly, it should be understood that the circuit pattern 120 and the circuit element member 130 may also be surrounded by the protective layer 160.

In other words, the protective layer 160 is disposed to surround one surface of the substrate member 110 that is coupled and electrically conducted to the LED member 140, i.e., one surface of the substrate member 110 that faces the inner layer 23 or the interior space 30.

The protective layer 160 may be formed by a process of any form that allows the protective layer 160 to protect the substrate member 110, the circuit pattern 120, the circuit element member 130, or the LED member 140. In one embodiment, the protective layer 160 may be formed by a conformal coating process or an encapsulation process.

As an alternative, the protective layer 160 may be provided in the form of a transparent adhesive or a transparent adhesive film and may be formed in a form covering the substrate member 110, the circuit pattern 120, the circuit element member 130, or the LED member 140.

The protective layer 160 may be formed of a light-permeable material. This is to allow the light L emitted from the LED member 140 to pass through the inner layer 23 and extend into the interior space 30 without interference with the protective layer 160. In one embodiment, the protective layer 160 may be formed to be transparent.

In one embodiment, the protective layer 160 may be configured to cool another component, especially the LED member 140, of the light emitting module 100. To this end, the protective layer 160 may be formed of a material that facilitates heat dissipation with other components that come into contact with or are adjacent to the protective layer 160.

In the embodiment in which the protective layer 160 is included, the protective layer 160 surrounding the LED member 140 may come into contact with the inner layer 23. In other words, the inner layer 23, the protective layer 160, the LED member 140, and the substrate member 110 are sequentially stacked in that order in the direction from the interior space 30 toward the outside.

The above-described concavo-convex portion 150 and protective layer 160 may be selectively included. That is, the light emitting module 100 may only include the substrate member 110, the circuit pattern 120, the circuit element member 130, and the LED member 140 or may further include any one or more of the concavo-convex portion 150 and the protective layer 160.

That is, the concavo-convex portion 150 and the protective layer 160 may be separately provided and coupled to the light emitting module 100, instead of being included in the light emitting module 100.

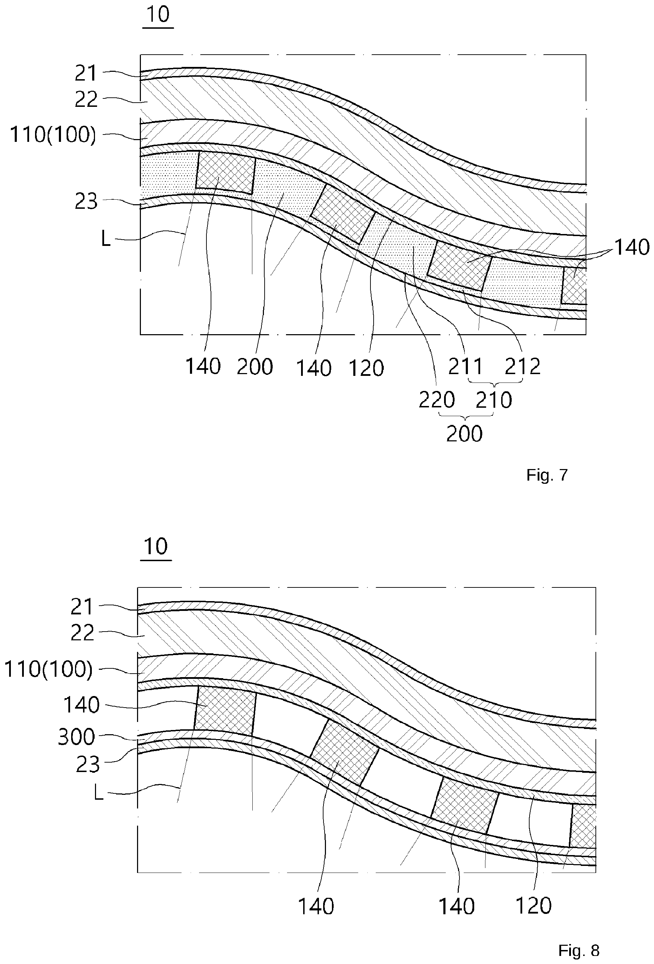

Referring to FIG. 7, the vehicle lighting device 10 according to an illustrated embodiment includes the support module 200.

The support module 200 is disposed between the inner layer 23 and the light emitting module 100 and configured to support the light emitting module 100. Due to the support module 200, the light emitting module 100 may be stably coupled to the frame 20, specifically, the mold layer 22 and the inner layer 23.

Also, in the embodiment in which the support module 200 is included, even when pressure in the direction from the interior space 30 toward the outside is applied to the inner layer 23, the applied impact may be absorbed by the support module 200. Accordingly, deformation of the inner layer 23 may be prevented, and damage to the light emitting module 100 may be prevented.

That is, the support module 200 is formed to surround the light emitting module 100, especially the circuit element member 130 or the LED member 140, from one side that faces the inner layer 23 or the interior space 30. Accordingly, protrusion of the circuit element member 130 or the LED member 140 may be prevented.

In one embodiment, the support module 200 may be configured to accommodate the circuit element member 130 or the LED member 140. That is, in the embodiment illustrated in FIG. 7, the support module 200 is disposed to surround surfaces of the LED member 140 excluding a surface thereof coupled to the substrate member 110, i.e., side surfaces and a lower surface of the LED member 140.

In this embodiment, a space for accommodating the light emitting module 100 may be formed inside the support module 200.

The support module 200 may be formed in a shape that corresponds to the shape of the light emitting module 100 and the inner layer 23. In the illustrated embodiment, the support module 200 includes a support concavo-convex portion 210 which has a shape corresponding to the shape of the light emitting module 100 and a support surface portion 220 which has a shape corresponding to the shape of the inner layer 23.

As an alternative, one side of the support module 200 that faces the light emitting module 100 may be formed in a shape other than a concavo-convex shape. That is, the one side of the support module 200 may be formed in any shape that allows the one side to prevent or relieve protrusion of the circuit element member 130 or the LED member 140. From this, it should be understood that the support module 200 is formed to be flexible.

The support module 200 may be formed of a flexible material. This is to allow the support module 200 to be formed to correspond to the shapes of the mold layer 22, the inner layer 23, and the light emitting module 100 coupled thereto and absorb impact applied from the outside.

The support module 200 may be formed of a light-permeable material. This is to allow the light L emitted from the light emitting module 100 to sequentially pass through the support module 200 and the inner layer 23 and extend into the interior space 30. Accordingly, even when the light emitting module 100 is surrounded by the support module 200, the light L emitted from the light emitting module 100 may pass through the inner layer 23 and be radiated toward the interior space 30.

The support module 200 may be formed of a material that is soft but may harden over time or when heated. In this embodiment, the support module 200 may be formed of a flexible material and stably coupled to the inner layer 23 and the light emitting module 100 having various shapes.

The above-described support module 200 may be selectively included.

In one embodiment, the support module 200 may be formed of a soft synthetic resin material including polyurethane (PU) or polyethylene (PE) or manufactured in the form of a soft film to cover the light emitting module 100.

Referring to FIG. 8, the vehicle lighting device 10 according to an illustrated embodiment includes the transmission module 300.

The transmission module 300 selectively transmits the light L emitted from the light emitting module 100 so that a predetermined image is formed on the inner layer 23 or in the interior space 30.

The transmission module 300 is coupled to the inner layer 23. The transmission module 300 is stacked between the inner layer 23 and the light emitting module 100 (specifically, the LED member 140) and is stacked on an upper side of the inner layer 23 in the embodiment illustrated in FIG. 8.

In the illustrated embodiment, the transmission module 300 includes a first portion 310 and a second portion 320.

One portion, i.e., the first portion 310, of the transmission module 300 is formed of a light-permeable material or formed to be penetrated. The light L heading toward the first portion 310 among light L emitted from the light emitting module 100 may pass through the first portion 310 and be radiated toward the inner layer 23 and the interior space 30.

Also, another portion, i.e., the second portion 320, of the transmission module 300 is formed of a non-light permeable material. The light L heading toward the second portion 320 among the light L emitted from the light emitting module 100 is blocked by the second portion 320.

Accordingly, the light L emitted from the light emitting module 100, specifically, the LED member 140, may form an image with a form corresponding to the shapes of the first portion 310 and the second portion 320 of the transmission module 300 on the inner layer 23 or in the interior space 30.

The first portion 310 of the transmission module 300, i.e., a region through which the light L emitted from the LED member 140 passes, may be formed of a character, a figure, a picture, a motion, or a combination thereof.

The transmission module 300 is disposed between the LED member 140 and the inner layer 23. In one embodiment, the transmission module 300 may come into contact with or be coupled to each of the LED member 140 and the inner layer 23. The transmission module 300 may be configured to support the light emitting module 100.

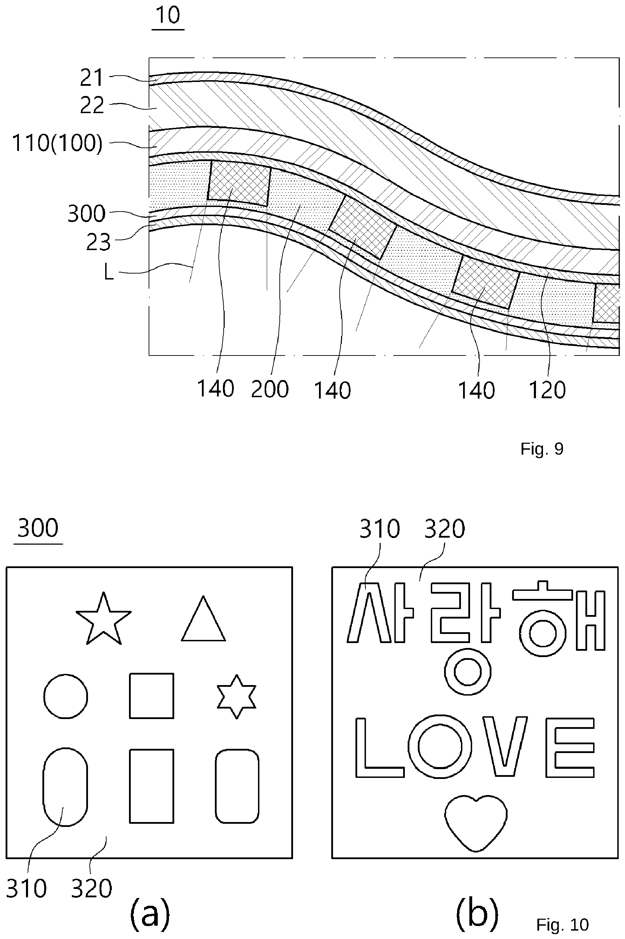

As illustrated in FIG. 9, in an embodiment in which both the support module 200 and the transmission module 300 are included, the transmission module 300 may be disposed between the support module 200 and the inner layer 23. That is, in this embodiment, the inner layer 23, the transmission module 300, the support module 200, and the light emitting module 100 may be sequentially stacked in that order.

In this embodiment, it should be understood that the light L emitted from the light emitting module 100 sequentially passes through the support module 200, the transmission module 300, and the inner layer 23 and extends into the interior space 30.

Referring to FIG. 10, examples of images of various forms that are formed by the first portion 310 and the second portion 320 of the transmission module 300 are illustrated.

As illustrated in FIG. 10A, the first portion 310 may be formed of figures of various shapes. Also, as illustrated in FIG. 10B, the first portion 310 may be formed of characters of various shapes.

Consequently, the transmission module 300 may selectively transmit the light L emitted from the light emitting module 100 and form predetermined images of various forms. This will be described in detail below.

The above-described transmission module 300 may be selectively included to transmit the light L emitted from the light emitting module 100 and form predetermined images of various forms.

The above-described vehicle lighting device 10 according to an embodiment of the present invention may be coupled to the frame 20 of the vehicle 1 and irradiate the interior space 30 with the light L to form images of various forms. Also, the vehicle lighting device 10 may radiate the light L of various forms so that various images are formed in the interior space 30.

Here, a control signal for controlling the light emitting module 100 so that a predetermined image is formed may be generated or changed by a manufacturer of the vehicle 1 or a manufacturer of the vehicle lighting device 10. Alternatively, the control signal may be generated or changed by a user of the vehicle 1 or vehicle lighting device 10.

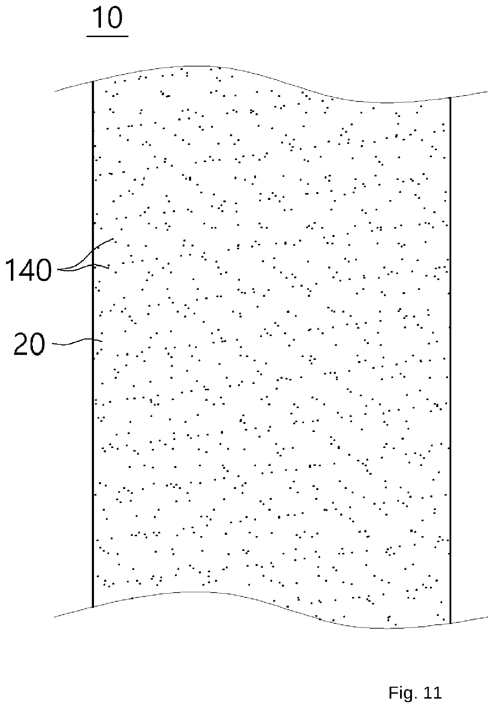

Hereinafter, examples of various images formed by the vehicle lighting device 10 according to an embodiment of the present invention will be described with reference to FIGS. 11 to 16.

Referring to FIG. 11, an embodiment in which an image in the form of a star cluster is formed by the vehicle lighting device 10 according to an embodiment of the present invention is illustrated.

In this embodiment, some of the plurality of LED members 140 are turned on or blink, and the rest of the plurality of LED members 140 are turned off. Here, the LED members 140 that are turned on or blink and the LED members 140 that are turned off may be randomly selected.

Also, color, brightness, saturation, luminous intensity, illumination, luminance, an angle of irradiation, blinking, etc. of light L emitted from the LED members 140 that are turned on or blink may be controlled independently from each other. Accordingly, images formed by the light L emitted from the LED members 140 may also have various forms, and thus the sense of realism may be improved.

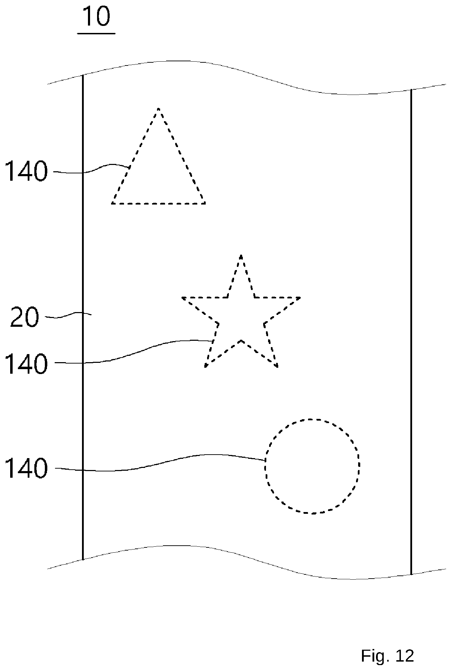

Referring to FIG. 12, an embodiment in which images in the form of various figures are formed by the vehicle lighting device 10 according to an embodiment of the present invention is illustrated.

That is, in the illustrated embodiment, a triangular image is formed at the upper left side, a star-shaped image is formed at the center, and a circular image is formed at the lower right side.

In this embodiment, some of the plurality of LED members 140 are turned on, and the rest of the plurality of LED members 140 are turned off. Here, the LED members 140 that are turned on and the LED members 140 that are turned off may be determined based on the figures.

Also, color, brightness, saturation, luminous intensity, illumination, luminance, an angle of irradiation, blinking, etc. of light L emitted from the LED members 140 that are turned on may be controlled independently from each other. Accordingly, images formed by the light L emitted from the LED members 140 may also have various forms, and thus the occupants' satisfaction may be increased.

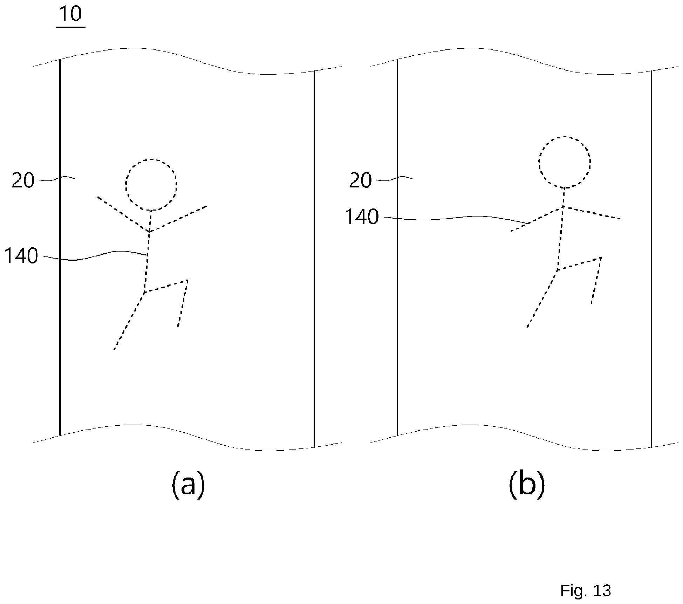

Referring to FIG. 13, an embodiment in which an image in the form of motion is formed by the vehicle lighting device 10 according to an embodiment of the present invention is illustrated.

That is, a human body image formed to be skewed to the left (see FIG. 13A) moves to the right as time passes (see FIG. 13B). Here, the form of the image also changes from a state in which both arms are raised to a state in which both arms are lowered. In this way, an image in the form of motion may be expressed.

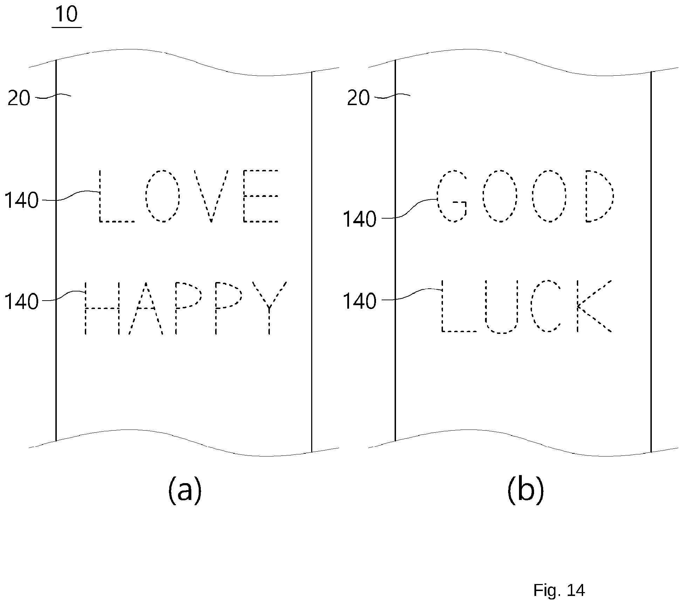

Referring to FIG. 14, another embodiment in which an image in the form of motion is formed by the vehicle lighting device 10 according to an embodiment of the present invention is illustrated.

That is, referring to FIG. 14A, images in the form of characters, such as "LOVE" at an upper side and "HAPPY" at a lower side, are formed on the frame 20 (that is, the inner layer 23). Referring to FIG. 14B, images in the form of different characters, such as "GOOD" at the upper side and "LUCK" at the lower side, are formed on the frame 20 as time passes.

Even in this embodiment, as in the embodiment illustrated in FIG. 12, some of the plurality of LED members 140 are turned on, and the rest of the plurality of LED members 140 are turned off. Here, the LED members 140 that are turned on and the LED members 140 that are turned off may be determined based on predetermined images to be expressed.

Here, as time passes, the LED members 140 that are turned on and the LED members 140 that are turned off among the plurality of LED members 140 may be changed. Consequently, images formed by the light L emitted from the plurality of LED members 140 may be changed over time.

Accordingly, since the form of images formed on the inner layer 23 or in the interior space 30 changes over time, the occupant's boredom may be reduced even when the vehicle 1 is driven for a long time.

In the illustrated embodiments, cases where images are changed over time from figure to figure or character to character are illustrated. As an alternative, an image in the form of any one of the above-described characters, figures, and pictures may be changed to an image in the form of any one or more of characters, figures, and pictures to form an image in the form of motion.

Referring to FIG. 15, an embodiment in which LED members 140 disposed in a specific region of the substrate member 110 emit brighter light so that the vehicle lighting device 10 may serve as an indoor light without a separate indoor light is illustrated.

In an embodiment in which the substrate member 110 is formed to have an area that corresponds to the area of the inner layer 23 of the frame 20, a surface of the substrate member 110 that is coupled to the LED member 140, i.e., the lower surface of the substrate member 110 in the illustrated embodiment, may be divided into a plurality of regions.

Here, the LED members 140 disposed in a specific region defined as the intensive region A among the plurality of regions may be controlled to emit light L of which any one or more of illumination, luminous intensity, and luminance are higher than those of light L emitted from the LED members 140 disposed in regions other than the intensive region A.

Also, in an embodiment in which the substrate member 110 is formed to have an area smaller than the area of the inner layer 23 of the frame 20, i.e., an embodiment in which the light emitting module 100 is provided to be modularized, the inner layer 23 may be divided into a plurality of regions.

Here, the LED members 140 of the light emitting module 100 that are disposed in a specific region defined as an intensive region A among the plurality of regions may be controlled to emit light L of which any one or more of illumination, luminous intensity, and luminance are higher than those of light L emitted from the LED members 140 disposed in regions other than the intensive region A.

In one embodiment, the light L emitted from the LED members 140 disposed in the intensive region A may be light L of which the illumination, luminous intensity, or luminance is higher than that of light L emitted from an indoor light according to the related art.

That is, in this embodiment, the LED members 140 disposed in the intensive region A may serve as an indoor light. It should be understood that this may be able to be implemented in both the case where the light emitting module 100 is provided as a single light emitting module 100 and configured to cover the inner layer 23 and the case where the light emitting module 100 is provided as a plurality of light emitting modules 100 and the plurality of light emitting modules 100 are each configured to partially cover the inner layer 23.

Here, the position of the intensive region A may be changed. That is, since the intensive region A is defined as a specific region in which a plurality of LED members 140 are disposed, the position of the intensive region A may be changed by a control signal applied thereto.

Therefore, unlike the conventional indoor light that is fixed at a specific position, light L may be intensively radiated toward an arbitrary region of the interior space 30 where the light L needs to be focused. Accordingly, not only is it possible to replace the conventional indoor light, but also it is possible to control the intensity and direction of the radiated light L according to the occupant's situation such that user convenience is improved.

Further, an image implemented in the intensive region A may be formed to be brighter than an image implemented in other regions. In this way, the occupant's attention may be drawn and a visual effect may be improved.

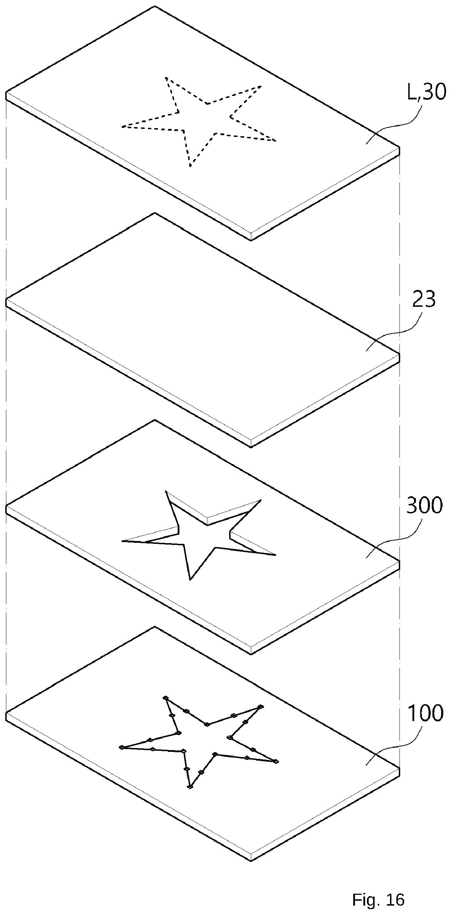

Referring to FIG. 16, an operation state of the vehicle lighting device 10 according to an embodiment of the present invention is conceptually illustrated. The light emitted from the light emitting module 100 passes through the transmission module 300 and the inner layer 23 and forms a predetermined image in the interior space 30.

According to the configurations described above, a vehicle lighting device and a vehicle including the same according to an embodiment of the present invention allow effective application of the vehicle lighting device according to the shape of the vehicle.

Also, according to the configurations described above, the vehicle lighting device and vehicle including the same according to an embodiment of the present invention allow a space inside the vehicle to be irradiated with light while the size of the space inside the vehicle is maintained.

Also, according to the configurations described above, the vehicle lighting device and vehicle including the same according to an embodiment of the present invention allow images of various forms to be formed in a space inside the vehicle.

Also, according to the configurations described above, the vehicle lighting device and vehicle including the same according to an embodiment of the present invention allow prevention of damage to a component for emitting light.

In addition, according to the configurations described above, the vehicle lighting device and vehicle including the same according to an embodiment of the present invention allow an exterior to be aesthetically pleasing.

Advantageous effects of the present invention are not limited to those mentioned above and should be understood as including any effect deducible from the detailed description of the present invention or configurations of the invention described in the appended claims.

Embodiments of the present invention have been described above, but the spirit of the present invention is not limited by the embodiments proposed herein. Those of ordinary skill in the art who understand the spirit of the present invention may easily propose other embodiments by addition, modification, omission, or the like of components within the scope of the same spirit, but such embodiments also belong to the scope of the spirit of the present invention.

In particular, the invention relates to the following preferred embodiments:
Embodiment 1. A vehicle lighting device irradiating an interior space of a vehicle with light, the vehicle lighting device comprising a light emitting module configured to irradiate the interior space with light transmitted through an inner layer surrounding the interior space, wherein the light emitting module comprises:
   a substrate member formed of a flexible material;
   a circuit pattern printed on the substrate member and electrically conducted to the outside to receive a control signal and an applied voltage;
   a circuit element member configured to be coupled and electrically conducted to the circuit pattern to process the control signal and the applied voltage; and
   a light emitting diode (LED) member coupled to the substrate member and electrically conducted to the circuit pattern and the circuit element member to emit the light according to the control signal and the applied voltage transmitted thereto.
Embodiment 2. The vehicle lighting device of embodiment 1, wherein, due to the inner layer, a portion of the light emitted from the LED member is transmitted and another portion of the light is blocked, creating an indirect mood lighting atmosphere.
Embodiment 3. The vehicle lighting device of embodiment 1, wherein the substrate member is configured to accommodate the circuit element member or the LED member to prevent protrusion thereof and includes a concavo-convex portion that is moldable by a heat forming technique,
   wherein the concavo-convex portion includes a concave portion configured to accommodate the circuit element member or the LED member and a convex portion configured to surround the concave portion.
Embodiment 4. The vehicle lighting device of embodiment 1, further comprising a protective layer configured to surround one or more of the substrate member, the circuit element member, and the LED member,
   wherein the protective layer is disposed between the light emitting module and the inner layer.
Embodiment 5. The vehicle lighting device of embodiment 4, wherein the protective layer is formed by a conformal coating process or an encapsulation process or is configured in the form of any one or more of a transparent adhesive and a transparent adhesive film.
Embodiment 6. The vehicle lighting device of embodiment 1, further comprising a flexible support module which is disposed between the light emitting module and the inner layer and configured to be formed to surround the circuit element member or the LED member to prevent protrusion of the circuit element member or the LED member,
   wherein, in the support module, one side facing the inner layer is formed in a shape that corresponds to the inner layer.
Embodiment 7. The vehicle lighting device of embodiment 6, wherein the support module is formed of a material that is flexible and light-permeable, and the light emitted from the light emitting module passes through the support module and the inner layer and is radiated toward the interior space.
Embodiment 8. The vehicle lighting device of embodiment 1, further comprising a transmission module which is disposed between the LED member and the inner layer and includes one portion through which the light emitted from the LED member is transmitted and another portion configured to block the emitted light.
Embodiment 9. The vehicle lighting device of embodiment 8, wherein the light emitted from the LED member sequentially passes through the one portion of the transmission module and the inner layer to form a predetermined image in the interior space.
Embodiment 10. The vehicle lighting device of embodiment 9, wherein the one portion of the transmission module is formed of a character, a figure, a picture, a motion, or a combination thereof.
Embodiment 11. The vehicle lighting device of embodiment 1, wherein the light emitting module is modularized and provided as a plurality of light emitting modules, and the plurality of light emitting modules are disposed to correspond to the shape of the inner layer.
Embodiment 12. The vehicle lighting device of embodiment 1, wherein the circuit pattern is formed on the substrate member by any one or more of printing processes including a plate-making mask, stamping, dispensing, inkjet, laser, gravure, and a pad using a conductive paste.
Embodiment 13. The vehicle lighting device of embodiment 1, wherein the circuit element member and the LED member are mounted on the substrate member by any one or more of printing processes including a plate-making mask, stamping, dispensing, inkjet, gravure, and a pad using a conductive adhesive.
Embodiment 14. The vehicle lighting device of embodiment 1, wherein the light emitting module includes a dielectric region formed to cover the substrate member or the circuit pattern by any one or more of printing processes including a plate-making mask, stamping, dispensing, inkjet, laser, gravure, and a pad using a dielectric paste or a dielectric adhesive.
Embodiment 15. The vehicle lighting device of embodiment 14, wherein the circuit pattern and the dielectric region are formed as a plurality of circuit patterns and a plurality of dielectric regions, and the plurality of circuit patterns and the plurality of dielectric regions are alternately stacked.
Embodiment 16. The vehicle lighting device of embodiment 15, wherein the circuit element member and the LED member are disposed on the plurality of circuit patterns that are alternately stacked.
Embodiment 17. The vehicle lighting device of embodiment 1, wherein:
   the LED member is provided as any one or more of an LED, a mini LED, a micro LED, and an LED ink, and
   the light emitted from the LED member has a single color, red, green, and blue (RGB), or a combination thereof.
Embodiment 18. The vehicle lighting device of embodiment 1, wherein the circuit element member is provided as a plurality of circuit element members, and the plurality of circuit element members are configured to control the LED member according to the applied voltage and the control signal transmitted thereto.
Embodiment 19. The vehicle lighting device of embodiment 18, wherein at least some of the plurality of circuit element members are disposed apart from the substrate member.
Embodiment 20. The vehicle lighting device of embodiment 1, wherein:
   the LED member is provided as a plurality of LED members, and the plurality of LED members are disposed in different regions of the circuit pattern, and
   any one or more of luminous intensity, illumination, and luminance are higher in light emitted from the LED member disposed in one region among the plurality of LED members, as compared to light emitted from the LED member disposed in another region among the plurality of LED members.
Embodiment 21. The vehicle lighting device of embodiment 1, wherein:
   the LED member is provided as a plurality of LED members, and the plurality of LED members are disposed in different regions of the circuit pattern,
   any one or more of emission of light, and the direction, luminous intensity, illumination, luminance, and color of the emitted light are independently controlled for the plurality of LED members, and
   the light emitted from the plurality of LED members forms an image of a character, a figure, a picture, a motion, or a combination thereof.
Embodiment 22. The vehicle lighting device of embodiment 1, wherein the substrate member is formed of any one or more of a synthetic resin film, leather, artificial leather, fabric, nonwoven fabric, foam, and felt.
Embodiment 23. A vehicle comprising:
   an inner layer surrounding an interior space;
   a mold layer stacked while surrounding the inner layer from an outer side thereof; and
   a vehicle lighting device disposed between the inner layer and the mold layer to irradiate the interior space with light,
   wherein the vehicle lighting device includes a light emitting module configured to irradiate the interior space with light transmitted through the inner layer,
   the light emitting module includes a substrate member formed of a flexible material, a circuit pattern printed on the substrate member and electrically conducted to the outside to receive a control signal and an applied voltage, a circuit element member configured to be coupled and electrically conducted to the circuit pattern to process the control signal and the applied voltage, and an LED member coupled to the substrate member and electrically conducted to the circuit pattern and the circuit element member to emit the light according to the control signal and the applied voltage transmitted thereto, and
   a portion of the light emitted from the LED member is transmitted through the inner layer and advances into the interior space while the rest of the light is blocked by the inner layer.

## Claims

1. A vehicle lighting device (10) irradiating an interior space (30) of a vehicle (1) with light, the vehicle lighting device (10) comprising a light emitting module (100) configured to irradiate the interior space (30) with light transmitted through an inner layer (23) surrounding the interior space (30), wherein the light emitting module (100) comprises:
a substrate member (110) formed of a flexible material;
a circuit pattern (120) printed on the substrate member (110) and electrically conducted to the outside to receive a control signal and an applied voltage;
a circuit element member (130) configured to be coupled and electrically conducted to the circuit pattern (120) to process the control signal and the applied voltage; and
a light emitting diode (LED) member (140) coupled to the substrate member (110) and electrically conducted to the circuit pattern (120) and the circuit element member (130) to emit the light according to the control signal and the applied voltage transmitted thereto.

2. The vehicle lighting device (10) of claim 1, wherein, due to the inner layer (23), a portion of the light emitted from the LED member (140) is transmitted and another portion of the light is blocked, creating an indirect mood lighting atmosphere.

3. The vehicle lighting device (10) of claim 1, wherein the substrate member (110) is configured to accommodate the circuit element member (130) or the LED member (140) to prevent protrusion thereof and includes a concavo-convex portion (150) that is moldable by a heat forming technique,
wherein the concavo-convex portion (150) includes a concave portion (152) configured to accommodate the circuit element member (130) or the LED member (140) and a convex portion (151) configured to surround the concave portion (152).

4. The vehicle lighting device (10) of claim 1, further comprising a protective layer (160) configured to surround one or more of the substrate member (110), the circuit element member (130), and the LED member (140), is disposed between the light emitting module (100) and the inner layer (23), and
wherein the protective layer (160) is formed by a conformal coating process or an encapsulation process or is configured in the form of any one or more of a transparent adhesive and a transparent adhesive film.

5. The vehicle lighting device (10) of claim 1, further comprising a flexible support module (200) which is disposed between the light emitting module (100) and the inner layer (23) and configured to be formed to surround the circuit element member (130) or the LED member (140) to prevent protrusion of the circuit element member (130) or the LED member (140),
wherein, in the support module (200), one side facing the inner layer (23) is formed in a shape that corresponds to the inner layer (23), and
wherein the support module (200) is formed of a material that is flexible and light-permeable, and the light emitted from the light emitting module (100) passes through the support module (200) and the inner layer (23) and is radiated toward the interior space (30).

6. The vehicle lighting device (10) of claim 1, further comprising a transmission module (300) which is disposed between the LED member (140) and the inner layer (23) and includes one portion through which the light emitted from the LED member (140) is transmitted and another portion configured to block the emitted light,
wherein the light emitted from the LED member (140) sequentially passes through the one portion of the transmission module (300) and the inner layer (23) to form a predetermined image in the interior space (30), and
wherein the one portion of the transmission module (300) is formed of a character, a figure, a picture, a motion, or a combination thereof.

7. The vehicle lighting device (10) of claim 1, wherein the light emitting module (100) is modularized and provided as a plurality of light emitting modules (100), and the plurality of light emitting modules (100) are disposed to correspond to the shape of the inner layer (23).

8. The vehicle lighting device (10) of claim 1, wherein the circuit pattern (120) is formed on the substrate member (110) by any one or more of printing processes including a plate-making mask, stamping, dispensing, inkjet, laser, gravure, and a pad using a conductive paste.

9. The vehicle lighting device (10) of claim 1, wherein the circuit element member (130) and the LED member (140) are mounted on the substrate member (110) by any one or more of printing processes including a plate-making mask, stamping, dispensing, inkjet, gravure, and a pad using a conductive adhesive.

10. The vehicle lighting device (10) of claim 1, wherein the light emitting module (100) includes a dielectric region formed to cover the substrate member (110) or the circuit pattern (120) by any one or more of printing processes including a plate-making mask, stamping, dispensing, inkjet, laser, gravure, and a pad using a dielectric paste or a dielectric adhesive,
wherein the circuit pattern (120) and the dielectric region are formed as a plurality of circuit patterns (120) and a plurality of dielectric regions, and the plurality of circuit patterns (120) and the plurality of dielectric regions are alternately stacked, and
wherein the circuit element member (130) and the LED member (140) are disposed on the plurality of circuit patterns (120) that are alternately stacked.

11. The vehicle lighting device (10) of claim 1, wherein:
the LED member (140) is provided as any one or more of an LED, a mini LED, a micro LED, and an LED ink, and
the light emitted from the LED member (140) has a single color, red, green, and blue (RGB), or a combination thereof.

12. The vehicle lighting device (10) of claim 1, wherein the circuit element member (130) is provided as a plurality of circuit element members (130), and the plurality of circuit element members (130) are configured to control the LED member (140) according to the applied voltage and the control signal transmitted thereto, and
wherein at least some of the plurality of circuit element members (130) are disposed apart from the substrate member (110).

13. The vehicle lighting device (10) of claim 1, wherein:
the LED member (140) is provided as a plurality of LED members (140), and the plurality of LED members (140) are disposed in different regions of the circuit pattern (120), and
any one or more of luminous intensity, illumination, and luminance are higher in light emitted from the LED member (140) disposed in one region among the plurality of LED members (140), as compared to light emitted from the LED member (140) disposed in another region among the plurality of LED members (140).

14. The vehicle lighting device (10) of claim 1, wherein:
the LED member (140) is provided as a plurality of LED members (140), and the plurality of LED members (140) are disposed in different regions of the circuit pattern (120),
any one or more of emission of light, and the direction, luminous intensity, illumination, luminance, and color of the emitted light are independently controlled for the plurality of LED members (140), and
the light emitted from the plurality of LED members (140) forms an image of a character, a figure, a picture, a motion, or a combination thereof.

15. The vehicle lighting device (10) of claim 1, wherein the substrate member (110) is formed of any one or more of a synthetic resin film, leather, artificial leather, fabric, nonwoven fabric, foam, and felt.
